(19) Europäisches Patentamt
European Patent Office
Office européen des brevets

(11) Publication number: 0 200 670 A2

# (12) EUROPEAN PATENT APPLICATION

(21) Application number: 86630073.4

(22) Date of filing: 02.05.86

(51) Int. Cl.⁴: H 01 G 1/14
H 01 G 1/035

(30) Priority: 03.05.85 US 730468
24.04.86 US 839686

(43) Date of publication of application:
05.11.86 Bulletin 86/45

(84) Designated Contracting States:
BE DE FR GB IT

(71) Applicant: ROGERS CORPORATION
Main Street
Rogers, Conn. 06263(US)

(72) Inventor: Hernandez, Jorge M.
1920 East Jarvis
Mesa Arizona 85202(US)

(72) Inventor: Larson, Rodney W.
2458 West Keating
Mesa Arizona 85202(US)

(74) Representative: Meyers, Ernest et al,
Office de Brevets Freylinger & Associés 46 rue du
Cimetière B.P. 1153
L-1011 Luxembourg(LU)

## (54) Decoupling capacitor and method of formation thereof.

(57) A decoupling capacitor and method of forming the same, and a novel multilayer ceramic capacitor chip construction is presented. In the method, a conductor (14) having a lead (18) connected thereto is formed from a continuous strip of electrically conductive material (10), the strip having opposing planar surfaces. A dummy lead (20), associated with the conductor (14), but isolated therefrom, is also formed from the strip (10). Two such strips (10, 10') (lead frames) are then spaced apart in a parallel orientation and a strip of insulating material (28) having a plurality of openings or windows (34) therein is sandwiched betwen the two lead frames (10, 10'). A novel multi-layer ceramic capacitor chip (38) having conductive electrodes (46', 44') on the top and bottom surfaces thereof is inserted into each window (34) so that the top and bottom electrodes (46', 44') respectively contact a conductor from each lead frame. Preferably, conductive epoxy is used to effect an electrical and mechanical connection between the capacitor chip electrodes and the lead frame conductors (14, 14'). Thereafter, a top strip (30) of outer insulating material is positioned across from one opposing surface of a first conductive strip (10) and a bottom strip (32) of outer insulating material is positioned on another opposing surface of a second conductive strip (10'). The top and bottom outer insulating layers (30, 32) sandwiching the pair of parallel conductive strips (19, 10') are then heat tacked and hot press laminated to form a continuous strip of laminated material. Finally, the now sealed and laminated decoupling capacitor is severed from the pair of lead frames. The decoupling capacitor of the present invention will thus be both hermetically sealed and automatically insertable for use in conjunction with integrated circuit DIP inserter devices.

FIG. 1A

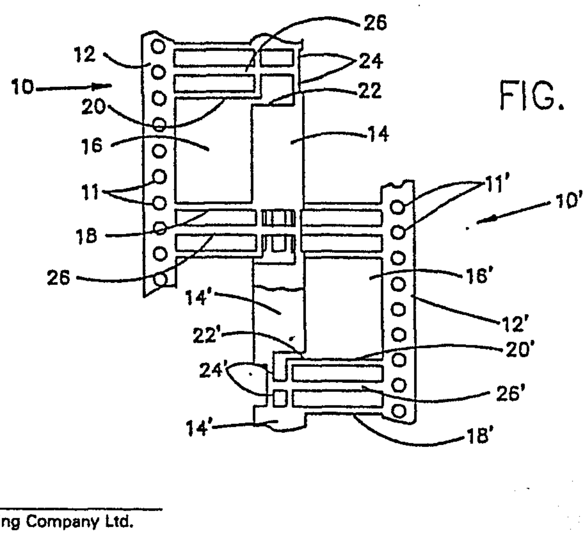


FIG. 1B

EP 0 200 670 A2

# Decoupling capacitor and method of formation thereof

This invention relates to the field of decoupling capacitors for integrated circuits. More particularly this invention relates to a novel and improved decoupling capacitor, and method of formation thereof, wherein the capacitors are formed from a pair of lead frames disposed in a parallel orientation and including multi-layer ceramic capacitor chips having top and bottom electrodes. This dual lead frame construction and specially configured multi-layer capacitor chip permits the decoupling capacitor to be formed from a lamination process without the use of any molding to form decoupling capacitors which are auto-insertable into printed circuit boards for use in conjunction with dual-in-line integrated circuits or other electronic components.

U.S. Patent No 4,502,101 discloses a decoupling capacitor for an integrated circuit package. The decoupling capacitor of that prior patent is a thin rectangular chip of ceramic material which is metallized on opposite sides and has leads from the metallized coatings on opposite sides of the chip at two points adjacent a pair of diagonally opposed corners of the rectangularly shaped ceramic chip. The two leads are bent downwardly, and the decou-ling capacitor assembly is encapsulated in a film of nonconductive material. In accordance with the teachings of that prior patent, the decoupling capacitor is dimensioned so as to be received in the space between the two rows of leads extending from a conventional dual-in-line integrated circuit. The two leads from the decoupling capacitor are plugged into a printed circuit board, with these leads from the capacitor being inserted into the printed circuit through holes to which the ground and power supply conductors are connected. The associated integrated circuit or other electronic component is then positioned over the capacitor and inserted into

0200670

the board such that the power supply leads of the integrated circuit or other component will be positioned in the same through holes of the printed circuit board in which the two capacitor leads have been inserted.

The diagonally located leads or pins on the decoupling capacitor of U.S. Patent No 4,502,101 have resulted in a problem when it is desired to automatically insert the decoupling capacitors into the printed circuit board. Standard auto-insertion equipment is available for inserting integrated circuit elements into the printed circuit boards. The insertion heads on standard auto-insertion equipment grasp the integrated circuit about the bent terminal pins or leads of the integrated circuit. Since there are two symmetric rows of pins on the integrated circuit element, the auto-insertion equipment can grasp the integrated circuit element symmetrically and stably for insertion. However, when insertion of the decoupling capacitor of prior U.S. Patent No 4,502,101 is attempted with the same auto-insertion equipment, an unstable condition and misalignment results because of the fact that the decoupling capacitor, rather than having two symmetrical rows of pins, has only two pins at diagonally opposite corners of the rectangular capacitor. Because of the presence of only the two pins, the capacitor "cocks" in the insertion head with the result that misalignment occurs between the terminals of the capacitor in the corresponding holes on the printed circuit board.

Since it is extremely desirable to auto-insert the decoupling capacitors into the printed circuit boards, and since it is equally desirable to perform that auto-insertion with the same auto-insertion equipment used with the integrated circuit elements, a significant problem is encountered with the decoupling capacitor of the prior application, not from the standpoint of its electronic operability and effectiveness, but rather from the standpoint of adapting it to high volume assembly techniques.

A need also exists for a decoupling capacitor structure which is also auto-insertable, hermetically sealed, and capable of being manufactured by automated assembly processes.

U.S. Patent No 4,475,143 discloses one approach to solving the above discussed auto-insertion problem by the incorporation of dummy or stabilizing pins in a decoupling capacitor assembly. U.S. Patent Nos 4,491,895, 4,494,169, 4,494,170, 4,497,012, 4,511,951 and 4,532,572, present other constructions of and methods for forming decoupling capacitors with dummy pins or molded stabilizing lugs.

Presently used manufacturing procedures for decoupling capacitors of the type hereinabove discussed (i.e., which include dummy leads) are not particularly well suited for incorporating multi-layer monolithic ceramic capacitor chips as the capacitive element for the decoupling capacitor device. In effect then, this situation limits the capacitive element to be a single layer capacitor of limited obtainable capacitance per unit volume.

Many of these prior art methods of manufacturing decoupling capacitors utilize encapsulating molding as a technique in providing hermetically sealed components. One of the problems associated with conventional multi-layer ceramic capacitors using either transfer or injection molding, is the resultant relatively small total package thickness of about 1,14 mm (including stand-offs). This leads to a package wall thickness of about 0,2-0,025 mm, which is quite difficult to consistently provide using conventional state of the art molding methods.

It should be understood that there is a need for efficient and economical decoupling capacitors and methods of manufacture thereof having higher capacitance volumes for use in decoupling the new generation of integrated circuit devices, which are faster and consume more power (i.e., 256 K memory integrated circuits).

The above discussed and other problems of the prior art are overcome or substantially reduced by the new and improved decoupling capacitor of the present invention and the method of manufacture thereof; and a novel multilayer ceramic capacitor chip construction. The decoupling capacitor of the present invention is formed from a laminated structure consisting of a pair of lead frames having a parallel orientation and a specially adapted multi-layer capacitor chip with top and bottom conductive electrodes. The use of such a laminated structure provides a low cost, auto-insertable and reliable decoupling capacitor which includes high capacitance values as well as other desirable properties such as temperature stability of capacitance, as a result of the incorporation of multi-layer capacitor chips. The present invention thus presents a construction of and method for forming improved decoupling capacitors which are hermetically sealed, auto-insertable and manufactured in a pair of lead frames followed by a lamination process.

In accordance with the method of the present invention, a conductor having a lead connected thereto is formed from a continuous strip of electrically conductive material, the strip having opposing planar surfaces. A dummy lead, associated with the conductor, but isolated therefrom, is also formed from the strip. Two such strips (lead frames) are then spaced apart in a parallel orientation and a strip of insulating material having a plurality of openings or windows therein is sandwiched between the two lead frames. A multi-layer ceramic capacitor chip having conductive electrodes on the top and bottom surfaces thereof is inserted into each window so that the top and bottom electrodes respectively contact a conductor from each lead frame. Preferably, conductive epoxy is used to effect an electrical and mechanical connection between the capacitor chip electrodes and the lead frame conductors. Thereafter, a top strip of outer insulating material is positioned across from one opposing surface of a first conductive strip and a bottom strip of outer insulating material is positioned on another opposing surface of a second conductive strip. The top and bottom outer insulating layers sandwiching the pair of parallel conductive strips are then heat tacked and hot press laminated to form a continuous strip of laminated material. It will be appreciated that suitable adhesive coating is provided to the several layered components during assembly and prior to lamination; the adhesive being cured during lamination. Finally, the now sealed and laminated decoupling capacitor is severed from the pair of lead frames. The decoupling capacitor of the present invention will thus be both hermetically sealed and automatically insertable for use in conjunction with integrated circuit DIP inserter devices.

The above discussed and other features and advantages of the present invention will be apparent to and understood by those skilled in the art from the following detailed description and drawings.

Figure 1A is a plan view of a top lead frame used in forming a decoupling capacitor having a multi-layer ceramic chip therein in accordance with the present invention;

Figure 1B is a plan view of a bottom lead frame used in forming a decoupling capacitor having a multi-layer chip capacitor therein in accordance with the present invention;

Figure 2 is an exploded perspective view of the component layers used in forming a decoupling capacitor in accordance with the present invention prior to lamination;

Figure 3 is a perspective view of a multi-layer ceramic capacitor chip (MLC) used in forming a decoupling capacitor in accordance with the present invention;

Figure 4 is a cross-sectional elevation view of the MLC of Figure 3 along the line 4-4;

Figure 5 is an enlarged cross-sectional elevation view of a portion of the decoupling capacitor of Figure 3 subsequent to lamination;

Figure 6 is a plan view of the laminated assembly of decoupling capacitors in accordance with the present invention;

Figure 7 is a plan view of the singulated decoupling capacitors of Figure 6, prior to lead bending;

Figure 8 is a perspective view of a finished decoupling capacitor in accordance with the present invention;

Figure 9 is a plan view of a preferred multilayer capacitor chip (MLC) used in accordance with the present invention;

Figure 10 is a cross-sectional elevation view of the MLC of Figure 9 along the line 10-10;

Figure 11 is a plan view of a decoupling capacitor incorporating the MLC of Figure 9 in accordance with the present invention;

Figure 13 is a cross-sectional elevation view along the line 12-12 of Figure 11;

Figure 13 is a cross-sectional elevation view of a MLC in accordance with the prior art;

Figure 14 is a cross-sectional view along the line 14-14 of Figure 15 of a decoupling capacitor incorporating the MLC of Figure 13 in accordance with the prior art;

Figure 15 is a plan view of the decoupling capacitor of Figure 14 in accordance with the prior art;

Figure 16 is a graphical correlation of IMPEDANCE VS. FREQUENCY for the decoupling capacitor of Figures 14 and 15; and

Figure 17 is a graphical correlation of IMPEDANCE VS. FREQUENCY for the decoupling capacitor of the present invention.

The present invention presents a construction of and method for forming improved decoupling capacitors which are hermetically sealed, auto-insertable and manufactured in a lamination process.

Referring first to Figure 1A, a first or top lead frame used in accordance with the present invention is shown generally at 10. Top lead frame 10 is a continuous planar strip of conductive material i.e., copper, which is provided with openings 11 along one side edge or carrier strip thereof for registration and transport. It will be appreciated that Figure 1 shows only a small portion of a lead frame which is suitable for forming three decoupling capacitors in accordance with the present invention. It will further be appreciated that lead frame 10 is preferably a stamped part wherein all the components thereof are rigid. Thus, the desired lead frame configuration is formed by removing unwanted material from the strip of conductive material using any suitable and conventional technique.

Lead frame 10 includes a top conductor body portion 14 and is isolated from edge strip 12 substantially rectangular opening 16. Conductor 14 includes an electrically active pin or lead 18 integrally attached thereto and an electrically inactive dummy pin or lead 20 which projects into opening 16 and is isolated from conductor 14 by a space 22.

Similarly, bottom lead frame 10' is a continuous planar strip of conductive material, i.e., copper which is provided with openings 11' along one side edge or carrier strip 12' thereof for registration and transport. Bottom lead frame 10' also has a conductor 14' and includes an electrically active pin or lead 18' which is integrally attached thereto and an electrically inactive dummy pin or lead 20' which projects into opening 16' and is separated from conductor 14' by a space 22'. It will be appreciated that conductors 14 and 14' are supported within lead frame 10 and 10', i.e., on edge portions 12 and 12', by active leads 18 and 18' and conductor extensions 24 and 24' which are attached to continuous lateral support structures 26 and 26', respectively. Note that inactive leads 20 and 20' are supported and attached between the respective edge portions 12 and 12' of lead frame 10 and 10' and lateral support structures 26 and 26'. Finally, lead frame 10 should also include stand-off means 27 (Fig. 5), i.e., dimples for spacing back the decoupling capacitor from the circuit board.

Referring now to Figure 2 and in accordance with the method of the present invention, lead frames 10 and 10' as described hereinabove sandwich therebetween a central layer or strip of insulating material 28, and in turn, lead frames 10 and 10' are sandwiched between two strips of top and bottom insulating materials 30 and 32. All three insulating strips or layers 28, 30 and 32 are comprised of a suitable insulative polymeric material (i.e., Kapton, Ultem, etc.) and are provided with an adhesive coating (i.e. epoxy or other suitable adhesive material) on the respective surfaces which will contact lead frames 10 and 10'. Central insulative strip 28 is provided with a plurality of windows or openings 34 which will provide access to exposed portions of both conductors 14 and 14'. It will be appreciated that each window 34 of central insulative strip 28 will define a cavity or recess 36 which is configured to accept a multi-layer capacitor chip therein. After the lead frames 10 and 10', insulative strips 28, 30 and 32 and capacitor chips 38 are assembled as shown in Figure 2, the components are heat tacked and hot press laminated to form the laminated assembly of Figures 5 and 6.

An important feature of the present invention is the use of a specially configured novel multi-layer ceramic capacitor chip (MLC) identified at 38 in Figures 2-4. MLC 38 is comprised of a ceramic body 40 having interleaved layers of conductive electrodes 42. However, as will be discussed in greater detail hereinafter, unlike MLC's of conventional design, MLC 38 has its outermost electrodes 44 and 46 exposed to define top (electrode 46) and bottom (electrode 44) connecting surfaces. It will be appreciated that the actual number of interleaved layers of ceramic and metallization will depend upon the degree of desired capacitance.

Prior to assembly and lamination, drops 48 of conductive epoxy or other suitable electrically conductive adhesive material are placed on each conductor 14 and 14' as shown in Figures 2 and 5. During lamination, the conductive epoxy will cure to provide a strong electrical and mechanical bond between each respective top conductor 46 and bottom conductor 44 of the capacitor chip 38 and a respective top and bottom conductor 14 and 14'.

While the above discussion has been with regard to the use of a single multi-layer capacitor chip, it will be appreciated that more than one capacitor chip may be used in accordance with the present invention. It should be understood that the relative dimensioning of window 34 and cavity 36 will be varied in accordance with the number of and dimensions of the multilayer capacitor chips which are used.

Turning now to Figures 6-8, the individual decoupling capacitors now identified at 50 are then separated from edge portions 11 and 11' of respective lead frames 10 and 10' by severing lateral support structures 26 and 26' and a portion of the laminated assembly as indicated by the dashed lines between decoupling capacitors 50(a) and 50(b). Thereafter, the severed material is removed as shown between capacitors 50(b) and 50(c) in Figure 6. The electrically active leads 18 and 18' and electrically inactive "dummy" leads 20 and 20' are then singulated from laminated lead frames 10 and 10' (Figure 7) and bent downwardly about 90 degrees as shown in Figure 8.

The decoupling capacitor construction generally identified at 50 thus includes a pair of electrically isolated dummy leads 20 and 20' and a pair of electrically isolated dummy leads 20 and 20' and a pair of electrically active leads 18 and 18' which are integrally attached to top and bottom conductors 14 and 14', respectively In turn, top and bottom conductors 14 and 14' are electrically attached to top and bottom electrodes 46 and 44 of multi-layer capacitor 36. The whole assembly is laminated as discussed hereinabove with only the two electrically active leads 18 and 18' and the two electrically inactive leads 20 and 20' protruding outwardly therefrom.

As discussed, decoupling capacitor 50 utilizes a specially configured high capacitance multi-layer monolithic ceramic chip capacitor 38. Such a capacitor provides much higher capacitance values along with other desirable properties such as a flat capacitance vs. temperature characteristics, than are obtainable using convention planar single layer ceramic capacitors.

In accordance with the present invention, a pair of parallel, spaced lead frames utilizing an MLC having top and bottom conductors forms a laminated, hermetically sealed decoupling capacitor without the need for any type of molding (encapsulation) step. As a result, the disadvantages discussed hereinabove with providing consistency in molding is overcome with the process and decoupling capacitor of the present invention.

Referring again to Figures 3-5, while suitable for its intended purposes, multilayer capacitor chip 38 as shown therein does suffer from an important problem with regard to the conductive adhesive or solder 48 used to electrically and mechanically connect electrodes or conductors 44 and 46 to lead frames 10 and 10', respectively. Typically, MLC 38 is quite small in size (about 3 mm x 4,5 mm or 3,8 mm x 7,6 mm and between 0,33 - 0,38 mm in thickness. Consequently, as shown in Figure 4, the chances of conductive adhesive or epoxy covering or bridging one or both of the gap's between electrodes 44 and 46 thus producing a short circuit are quite good. There is also a likelihood of electrical contact between lead frames 14 and 14', and end terminations 64 and 66 (See Figure 4). It will be appreciated that this electrical contact will also produce a short circuit.

Turning now to Figures 9 and 10, in a preferred embodiment, the multilayer ceramic capacitor used in accordance with the present invention is shown generally at 38' and is provided with an insulating cap 60 and 62 surrouding and encapsulating the end terminations 64 and 66 of conductors 44' and 46', respectively. It is apparent that insulative caps 60 and 62 prevent any electrical bridging in the gaps between electrodes 44 and 46 (in contrast to MLC 38 in Figures 3-5). As a result the possibility of electrical shorting between electrodes 44' and 46' is eliminated, as well as the possibility of shorting between the lead frames 14 and 14' and the end terminations 64 and 66 of Figure 4.

Insulative caps 60 and 62 may be comprised of any suitable electrically insulative material including glass or epoxy. Preferably, the insulating material should provide a hermetic seal, good adhesion and high voltage breakdown.

In a preferred method of making MLC 38', even numbers of ceramic sheets 40' with screened electrode patterns 42' are laminated together such that the external planes expose electrodes. The laminates are then cut into individual chips and fired. After firing, a thin, preferably silver end termination 64 and 66 (band width less than 0,127 mm) is applied and fired. A second end termination 60 and 62 of dielectric glass is then applied (band width approximately 0,38 mm) which coats and insulates the silver end termination 60 and 62. The glass is then fired to yield a finished chip. Thus, end terminations 64 and 66 essentially interconnect alternating conductive sheets 42' with the outer conductive sheets 44' and 46' defining upper and lower electrodes.

In Figures 11 and 12, the preferred MLC 38' of Figures 9 and 10 is shown after assembly in a decoupling capacitor 50'. As is evident from the Figures, conductive adhesive 48' is precluded from bridging the gap between electrodes 44' and 46' by insulated coatings or end caps 60 and 62.

As previously discussed, conventional multilayer ceramic chip capacitors have utilized exposed electrodes at either end rather than the top and bottom electrode configuration of Figures 3, 4, 9 and 10. Such a conventional prior art MLC is shown generally at 68 in Figure 13. Prior art MLC 68 thus includes interleaved layers of ceramic 70 and metallization 72 with alternate layers of metallization 72 terminating at end electrodes 74 and 76. In Figures 14 and 15, an example of a decoupling capacitor used in the prior art which utilizes a multilayer capacitor chip such as is shown in Figure 13, is identified generally at 76. Decoupling capacitor 76 utilizes a single lead frame 78 (as contrasted to the pair of spaced lead frames used in the present invention), with MLC 68 being connected to conductors 80 and 82 of lead frame 78 by way of a pair of soldered joints 84 and 86. As shown schematically by the arrows in Figure 15 (illustrating lines of current), portions of the lead frames 80 and 82 will act as conductors that create a magnetic field (when current is passed therethrough) which stores magnetic energy and thereby creates relatively high inductance. Thus, use of a conventional MLC 68 in conjunction with a single plane lead frame construction will provide higher inductance which is undesirable because of poor high frequency noise suppression when in actual operation in conjunction with an integrated circuit.

An important feature of the present invention is that the electrical properties, particularly the inductance of the decoupling capacitor, is greatly improved relative to the prior art construction such as shown in Figures 14 and 15. This improvement in electrical performance is believed to be derived from the use of the novel multilayer capacitor chip 38 and 38' in conjunction with the "parallel plate" (two lead frame) construction of the decoupling capacitor as a whole. For example, in Figures 16 and 17, impedance vs. frequency is plotted for the single lead frame construction/conventional MLC construction of Figures 14 and 15 (Figure 16) and the "parallel plate"/novel MLC construction of Figures 5 and 12. These impedance curves show that the decoupling capacitor construction of the present invention has an inductance of about 16 % lower than the single lead frame/conventional MLC construction of the prior art. It will be appreciated that inductance is measured by the slope of the right side of each curve in Figures 16 and 17. As mentioned, this improved inductance leads to far better noise suppression at high frequencies. This improved impedance of the present invention can be supported by the theoretical considerations discussed with regard to the magnetic field shown in Figure 15. Accordingly, from among the many possible and practical conductor structures which can be used for decoupling capacitor, the "parallel plate" construction of the present invention (including the novel MLC of the present invention) is the least "inductive". In other words, the "parallel plate" construction of the present invention stores the least magnetic energy which causes the inductive effects or inductance.

It will be appreciated that the important improved electrical performance of the present invention is not obtainable using a parallel plate decoupling capacitor construction in conjunction with a conventional MLC such as is shown in Figure 13. This is because MLC 68 of Figure 13 utilizes electrodes at either end (rather than top and bottom) which preclude a parallel plate construction. Only by using the novel MLC 38 or 38' wherein the electrodes are positioned along the top and bottom (and are therefore parallel to the interleaved metallization 42 or 42') may the improved electrical performance (i.e., lower inductance) be achieved.

While the novel MLC 38 and 38' has been described for use in conjunction with a decoupling capacitor, it will be appreciated that MLC 38 or 38' may also be used in any other electronic application necessitating multilayer capacitors. For example, the novel parallel plate constructed MLC's of the present invention would find utility when used in power and/or signal distribution buss bars; such as the buss bars disclosed in U.S. Patent Nos 4,236,038; 4,236,046; 4,266,091; 4,342,881; 4,399,321; 4,403,108 and 4,436,953. Moreover, while MLC 38 or 38' will have relatively small dimensions when used in decoupling capacitor as described herein, the novel MLC may also be of larger sizes depending upon the particular application.

---

# C L A I M S

1. - A method of making a capacitor, including the steps of :

removing unwanted material from a first strip of electrically conductive material to define a first conductor having a first active lead connected thereto and a first dummy lead associated with said first conductor, but electrically isolated therefrom;

removing unwanted material from a second strip of electrically conductive material to define a second conductor having a second active lead connected thereto and a second dummy lead associated with said second conductor, but electrically isolated therefrom, said first and second conductive strips being spaced apart and parallel with said first and second conductors in alignment with one another;

placing a central strip of electrically insulative material between said first and second conductors, said central insulative strip having windows therethrough wherein each of said windows define a recess which provides access between said first and second conductors;

placing at least one multilayer capacitor element in said recess and between said first and second conductors, said capacitor element having opposed first and second conductive top and bottom surfaces, with said top conductive surface being in electrical contact with said first conductor and said bottom conductive surface being in electrical contact with said second conductor;

placing a first outer strip of electrically insulative material on said first conductors opposite said central insulative strip;

placing a second outer strip of electrically insulative material on said second conductors opposite said central insulative strip;

providing adhesive between said first and second conductors, first and second outer insulative strips and central insulative strip; and

bonding the above elements to form a laminated assembly with said first and second conductors, first and second outer insulative strips and central insulative strip being bonded together.

2. - A method as claimed in Claim 1, including providing electrically conductive adhesive between said capacitor element top conductor and said first conductor and said capacitor element bottom conductor and said second conductor.

3. - A method as claimed in Claim 1, wherein said step of removing unwanted material from said first and second strips of electrically conductive material further includes the steps of :

forming support structure for supporting said first and second conductive strips; and severing said support structure.

4. - A method as claimed in Claim 1, wherein said step of removing unwanted material from said electrically conductive material further includes the steps of

forming support structure for supporting said first and second leads and said dummy leads in said respective first and second conductive strips; and severing said support structure.

5. - A method as claimed in Claim 1, including :

forming registration holes in said strips of electrically conductive material.

6. - A method as claimed in Claim 1, wherein :

said active leads are at a first pair of diagonally opposed location and said dummy leads are at a second pair of diagonally opposed locations.

7. - A method as claimed in Claim 1, wherein :

said capacitive element is a ceramic material having interleaved conductive layers with a pair of opposed conductive top and bottom surfaces.

8. - A method as claimed in Claim 1, including

the step of :

providing set-off means in said laminated assembly.

9. - A method as claimed in Claim 1, including the further step of :

severing said laminated assembly from said first and second conductive strips.

10. - A method as claimed in Claim 2, wherein said electrically conductive adhesive is solder and including the step of :

reflowing said solder after providing it between said capacitor element and said first and second conductors.

11. - A method as claimed in Claim 1, wherein said windows are substantially rectangular.

12. - A method as claimed in Claim 1, wherein the bonding step comprises the steps of :

heat tacking the elements, and

hot press laminating the elements.

13. - A capacitor including :

a first electrical conductor (14),

a second electrical conductor (14') spaced from and in alignment with said first conductor (14),

a first active lead (18) extending from said first conductor (14) at a first position,

a second active lead (18') extending from said second conductor (14') at a second position,

a first dummy lead (20) associated with said first conductor (14), but electrically isolated therefrom at a third position,

a second dummy lead (20') associated with said second conductor (14'), but electrically isolated therefrom at a fourth position,

a central strip (28) of electrically insulative material between said first and second conductors (14, 14'), said central insulative strip (28) having a window (34) therethrough wherein said window defines a recess (36) which provides access between said first and second conductors (14, 14'),

at least one multilayer capacitive element (38) in said recess and between said first and second conductors (14, 14'), said capacitive element (38) having opposed first and second conductive top and bottom surfaces, with said top conductive surface being in electrical contact with said first conductor (14) and said bottom conductive surface being in electrical contact with said second conductor (14'), and

a first outer strip (30) of electrically insulative material on said first conductor (14) opposite said central insulative strip (28),

a second outer strip (32) of electrically insulative material on said second conductor (14') opposite said central insulative strip (28)

wherein the above elements are bonded together to form a laminated assembly.

14. - A capacitor as claimed in Claim 1, wherein said elements are bonded together with an adhesive.

15. - A capacitor as claimed in Claim 13, wherein said top and bottom conductive surfaces of said capacitive element (38) are bonded to said first and second conductors (14, 14') respectively.

16. - A capacitor as claimed in Claim 15, wherein said bonding is accomplished by a conductive adhesive.

17. - A capacitor as claimed in Claim 13, wherein said active leads (18, 18') are at a first pair of diagonally opposed locations and said dummy leads (20, 20') are at a second pair of diagonally opposed locations.

18. - A capacitor as claimed in Claim 13, wherein :

said capacitive element (38) is a ceramic material having a pair of opposed end surfaces and top and bottom surfaces (46, 44), said capacitive element also having interleaved conductive layers (42) with a pair of opposed conductive top and bottom surfaces on said respective top and bottom surfaces of said

ceramic material.

19. - A capacitor as claimed in Claim 18, including :

first and second conductive and terminations (64, 66) on said ceramic material end surfaces; and wherein

alternating layers of said interleaved conductive layers (42) terminate at said first and second conductive end terminations (64, 66) with said top and bottom conductive surfaces (46, 44) being connected and substantially transverse to respective first and second conductive end terminations (64, 66).

20. - A capacitor as claimed in Claim 22, including :

an electrically insulative cap (60, 62) being provided over each of said first and second conductive end terminations (64, 66) wherein said conductive end terminations (64, 66) are encapsulated and wherein electrical bridging between said top and bottom conductive surfaces (44, 46) and said first and second conductive end terminations (64, 66) is precluded by said insulative caps.

21. - A capacitor as claimed in Claim 23, wherein :

said cap (60, 62) is comprised of a material selected from the group comprising glass and epoxy.

22. - A capacitor as claimed in Claim 13, including :

set-off means in said laminated cover.

23. - A capacitor as claimed in Claim 13, wherein :

said windows (34) are substantially rectangular.

24. - An array of capacitors positioned between a pair of edge strips from which a pair of conductors and active and dummy leads of the capacitors are formed, each of said capacitors being in accordance with any one of Claims 13 to 23.

25. - A multilayer capacitor element comprising :

ceramic material (40') having a pair of opposed end surfaces and having top and bottom surfaces;

a plurality of parallel conductive layers (42') interleaved within said ceramic material with a first conductive layer (46') on said top surface of said ceramic material (40') and a second conductive layer (44') on said bottom surface of said ceramic material;

a first conductive end termination (66) on one of said opposed end surfaces of said ceramic material (40') and a second conductive end termination (64) on the other of said opposed end surfaces of said ceramic material (40'),

alternating layers of said interleaved conductive layers (42') terminating at said first and second conductive end terminations (66, 64) with said top and bottom conductive surfaces (46', 44') being connected and substantially transverse to respective first and second conductive end terminations (66, 64) whereby a gap is defined between each of said end terminations (66, 64) and one of said first or second conductive layers (46', 44').

26. - A capacitor as claimed in Claim 35, including an electrically insulative cap (60, 62) being provided over each of said first and second conductive end terminations (66, 64) wherein said conductive end terminations (66, 64) are encapsulated and wherein electrical bridging between said top and bottom conductive surface and said first and second conductive end terminations (66, 64) is precluded by said insulative caps (60, 62)

27. - A capacitor as claimed in Claim 36, wherein :

said insulative cap (60, 62) is comprised of a material selected from the group comprising glass and epoxy.

---

FIG. 1A

FIG. 1B

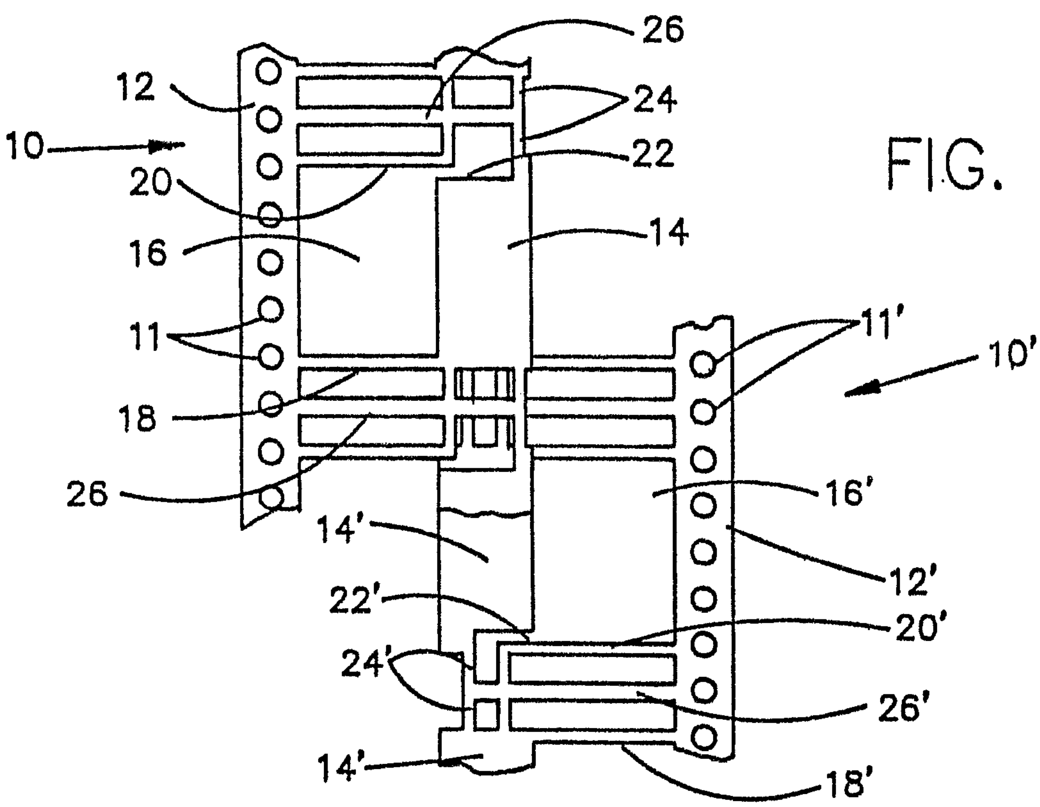


FIG. 2

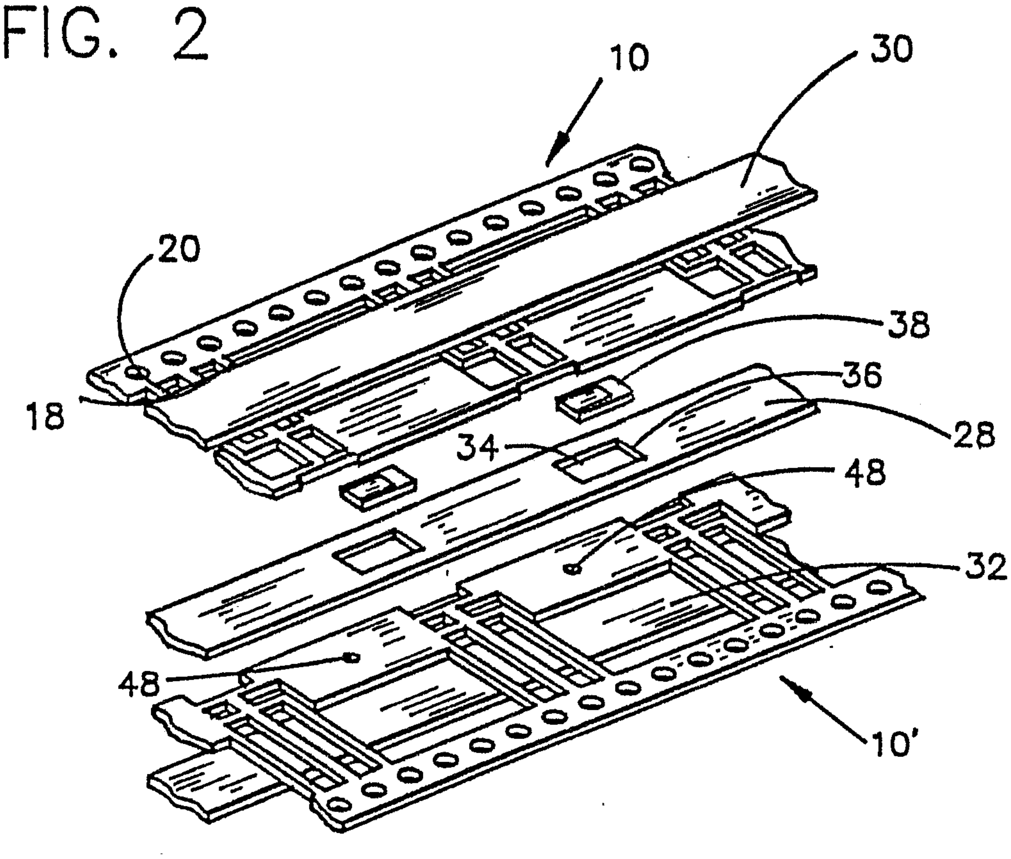

FIG. 3

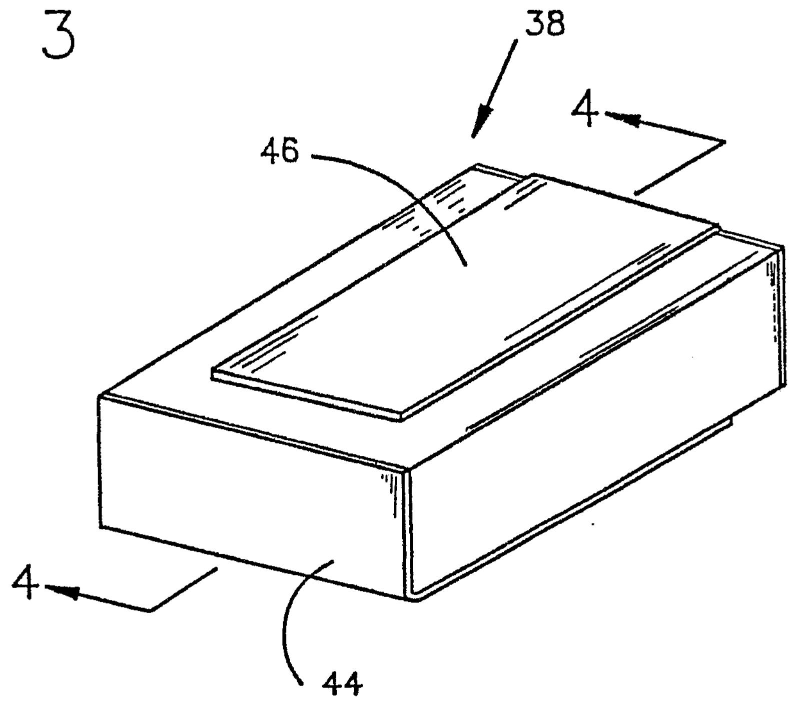


FIG. 4

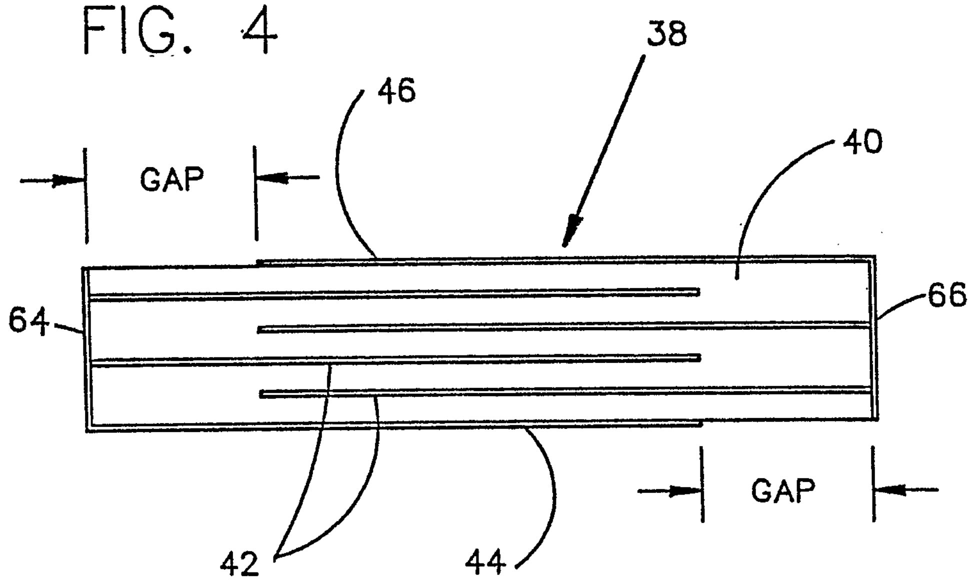

FIG. 5

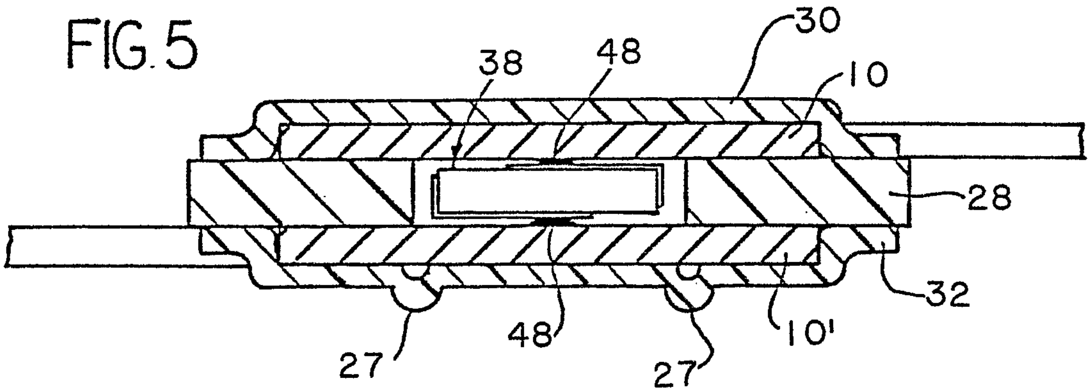


FIG. 6

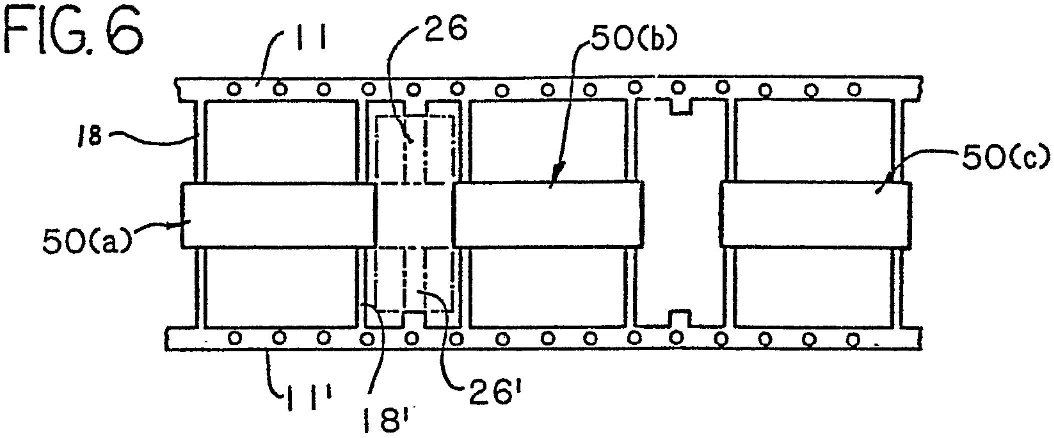


FIG. 7

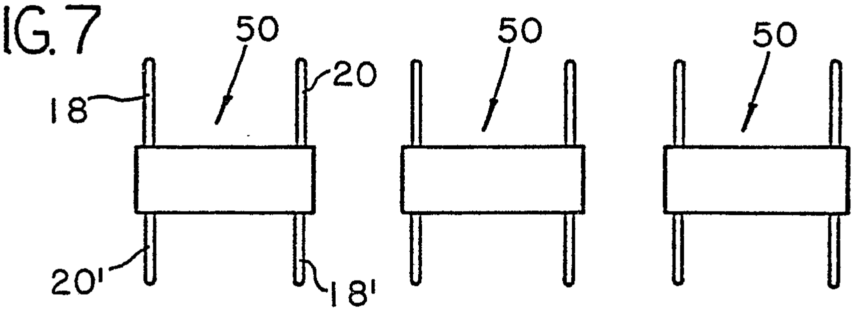


FIG. 8

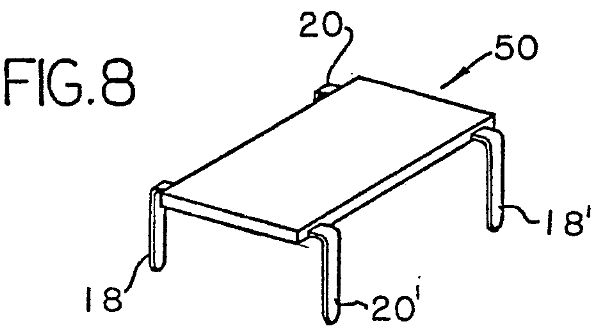

FIG. 9

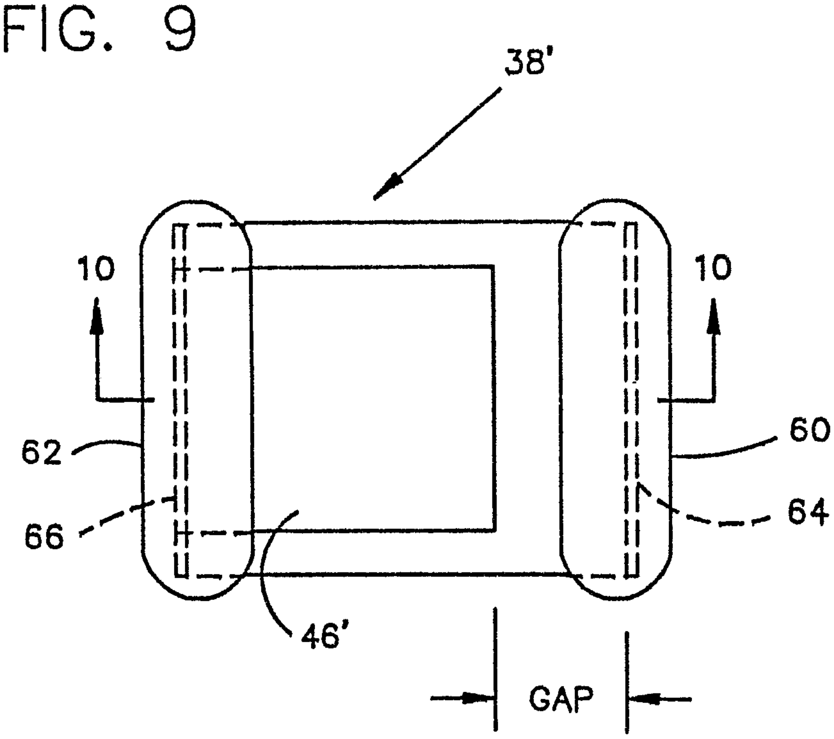


FIG. 10

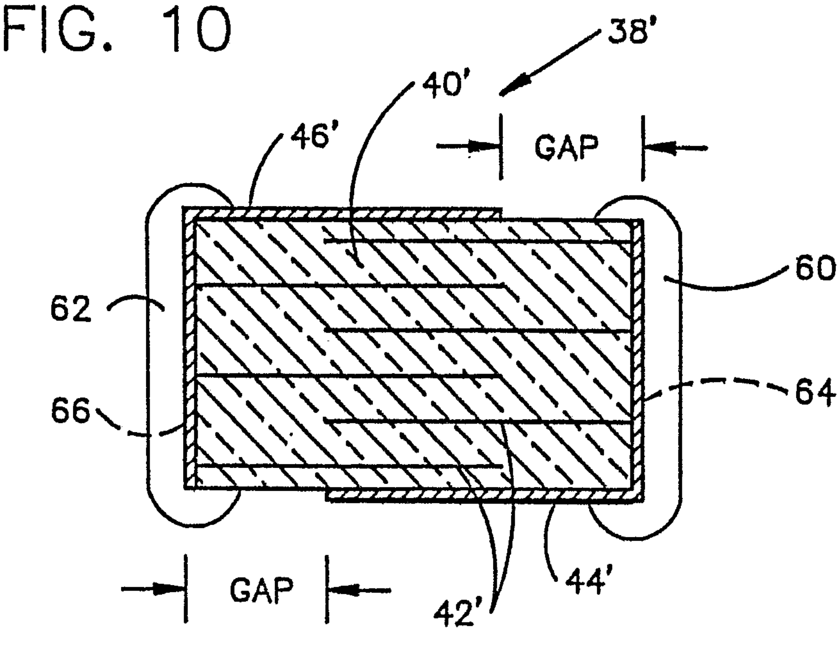

FIG. 11

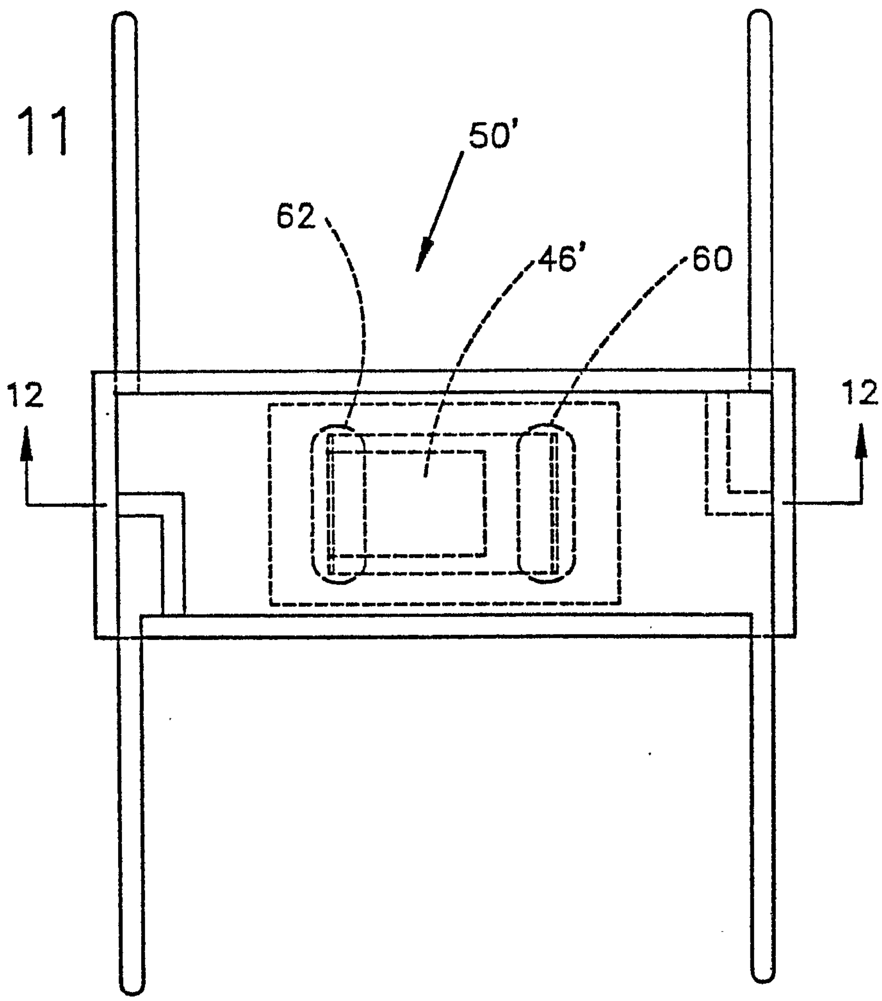


FIG. 12

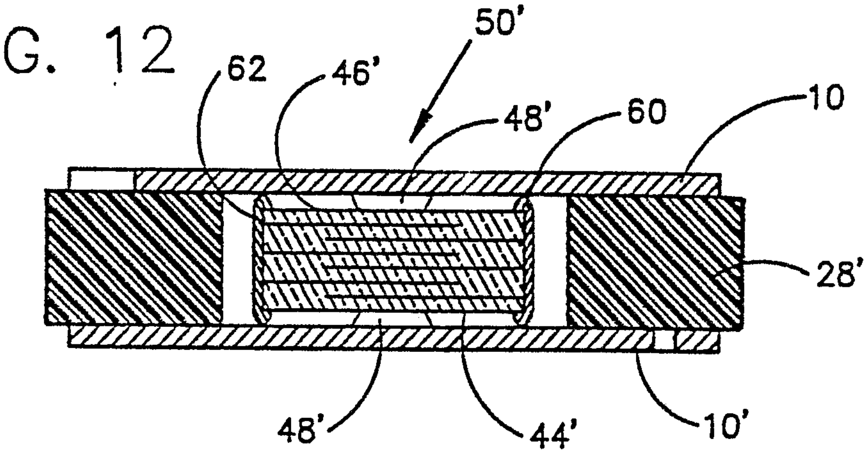

FIG. 13
(PRIOR ART)

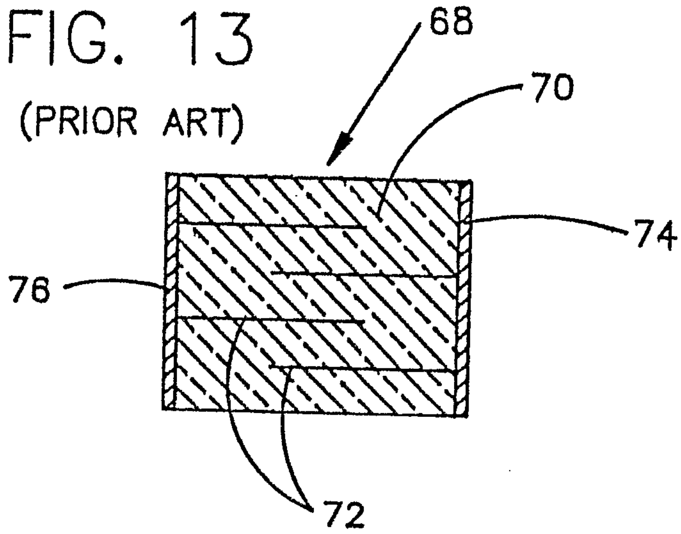


FIG. 14
(PRIOR ART)

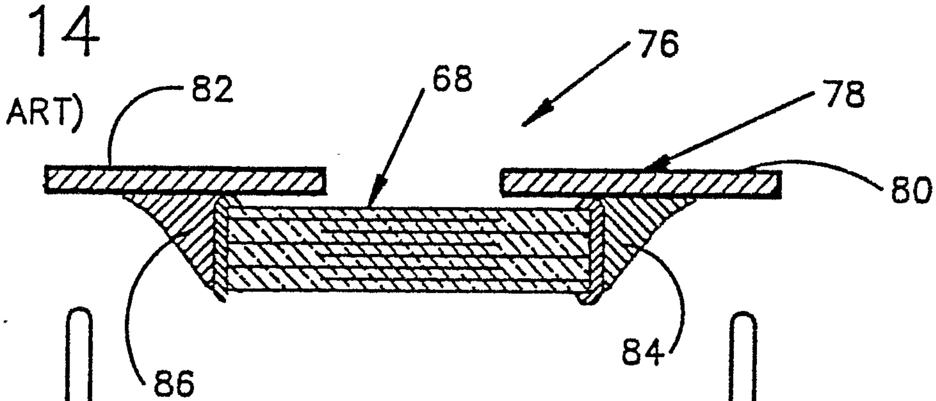


FIG. 15
(PRIOR ART)

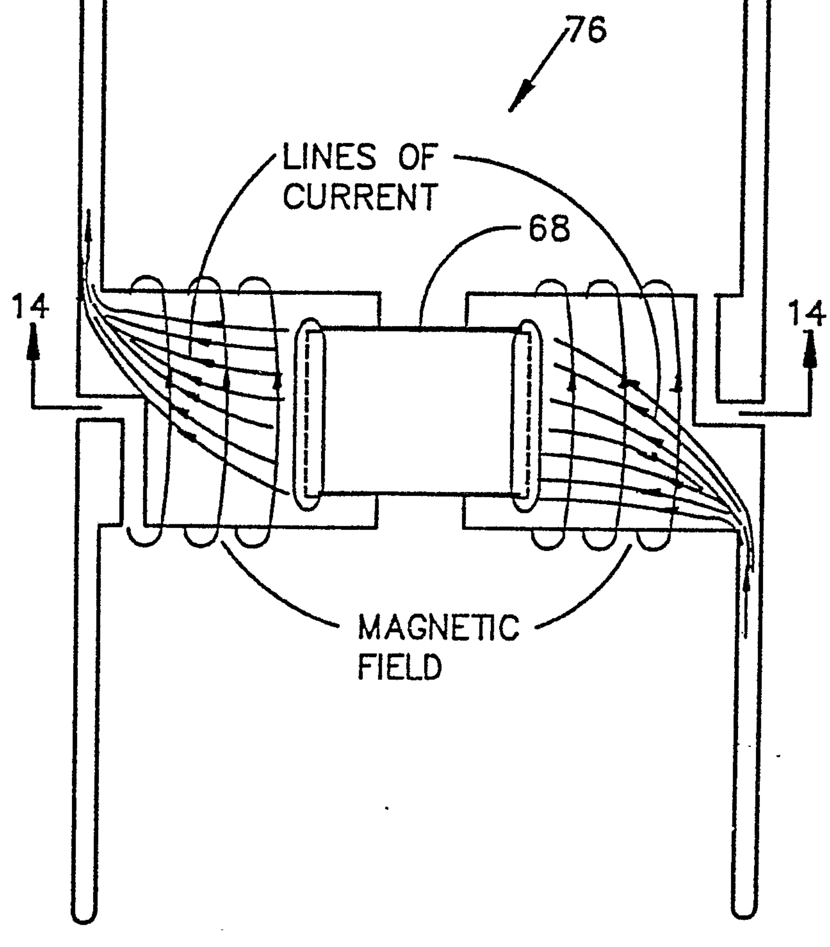

FIG. 16

IMPEDANCE CURVE

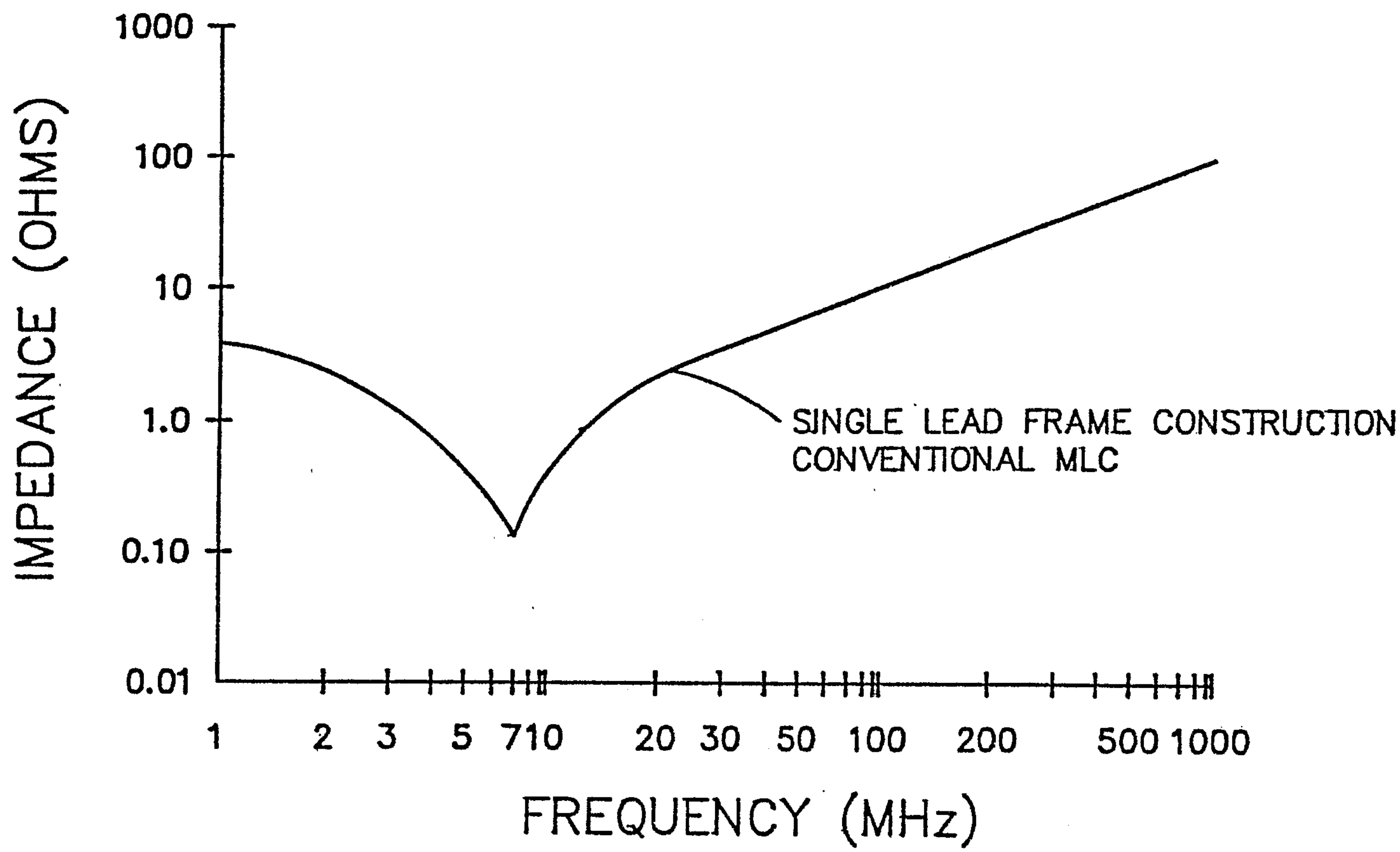

FIG. 17

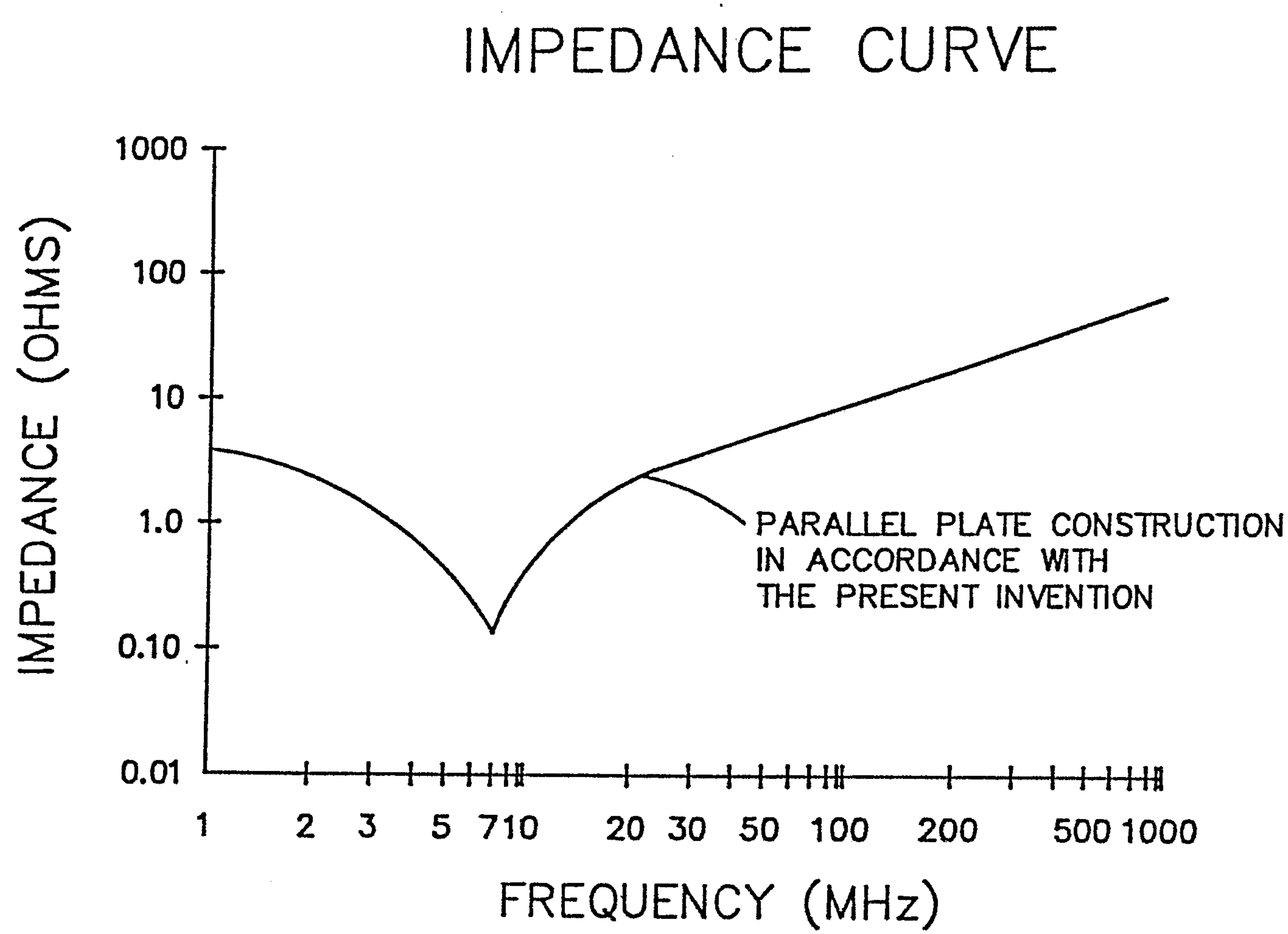
IMPEDANCE CURVE
IMPEDANCE (OHMS)
1000
100
10
1.0
0.10
0.01
1
2
3
5
710
20
30
50
100
200
500
1000
FREQUENCY (MHz)
PARALLEL PLATE CONSTRUCTION
IN ACCORDANCE WITH
THE PRESENT INVENTION